# EUROPEAN PATENT SPECIFICATION

(11) **EP 2 713 396 B1**
(45) Date of publication and mention of the grant of the patent: **08.03.2017**
(21) Application number: 12186414.4
(22) Date of filing: 27.09.2012
(51) Int. Cl.: H01L 25/075, H05K 1/02, H05K 1/18, H01L 33/62, H01L 33/64

(54) **Overlay circuit structure for interconnecting semiconductor light emitting devices and method of manufacturing the same**
Überlagerte Schaltungsstruktur zur Verbindung von lichtemittierenden Halbleiterbauelementen und Verfahren zur derren Herstellung
Structure de circuit de recouvrement pour interconnecter des dispositifs semi-conducteurs électroluminescents et procédé de fabrication correspondant

(43) Date of publication of application: 02.04.2014
(73) Proprietor: General Electric Company, Schenectady, NY 12345 (US)
(72) Inventor: Gowda, Arun Virupaksha, Niskayuna, NY New York 12309 (US); Cunningham, Donald Paul, Dallas, TX Texas 75229-2920 (US); Chauhan, Shakti Singh, Niskayuna, NY New York 12309 (US)
(74) Representative: Bedford, Grant Richard

(56) References cited:
- WO-A2-2012/112873
- DE-A1-102010 011 604
- US-A1- 2003 020 081
- US-A1- 2009 278 139
- US-A1- 2012 235 172

## Description

Embodiments of the invention relate generally to structures and methods for packaging light emitting semiconductor devices and, more particularly, to a flexible overlay circuit structure for interconnecting light emitting semiconductor devices.

Power semiconductor devices are semiconductor devices used as switches or rectifiers in power electronic circuits, such as switched mode power supplies, for example. Most power semiconductor devices are only used in commutation mode (i.e., they are either on or off), and are therefore optimized for this. One such device is a semiconductor light emitting device, with a prominent example being a light emitting diode (LED). LEDs are semiconductor chips that are packaged to emit radiation in response to an applied voltage or current. These LEDs are used in a number of commercial applications such as automotive, display, safety/emergency, and directed area lighting. LEDs may be fabricated using any materials which emit visible, ultraviolet, or infrared radiation. Currently, LEDs are typically assembled onto insulated metal substrates. The insulated metal substrates (IMS) include a metal baseplate (e.g., aluminum baseplate) covered by a thin layer of dielectric material (e.g., an epoxy-based layer) and a layer of copper, with the baseplate then being attached to a heatsink to provide cooling. One face of the LED chip/die is then typically soldered or silver adhesive attached to the IMS copper and the other terminal/face wirebonded to the IMS. Alternatively, the LED chip can be packaged in a first level package which can then be soldered to the IMS. In this first level package, one face of the LED chip is soldered or silver die attached to a pad on a substrate (metalized ceramic or polymer) and the other terminal/face is attached via wirebond to another pad on the same substrate. This first package may optionally include heat slugs.

It is recognized, however, that there are several drawbacks to the existing method of assembling arrays of LEDs on an IMS and of the wirebonding of the LED chips/dies to the IMS. For example, it is known that LEDs may be fabricated for use in a variety of products that have a curved surface or shape, including lighting products such as round lamp bulbs, flood lights, cylindrical flashlights, etc. In such products, it can be difficult to wirebond the LED chips/dies to a curved surface IMS. As another example, it is recognized that the form factor of the IMS limits applications or implementations of an array of LEDs to use only as a directional light source, when it may be desirable for the array of LEDs to be applied or implemented in more complex shapes, such as shapes typical in general incandescent lighting. As yet another example, it is recognized that layer of dielectric material in the IMS can add unnecessary thermal resistance that may negatively impact the performance and/or efficiency of the array of LEDs.

US 2009/0278139 describes an electrical device containing multiple light emitting diode (LED) dies each having respective first and second connectors suitable to receive current through the LED die. A common base layer of a first electrically conductive material has cavities into which at least one LED die is mounted with its second connector electrically connected by a conductive bonding material to the first conductive material of the base layer. One or more over-layer sections of a second electrically conductive material each are electrically connected by a bond to at least one of the first connector of a LED die. And an insulator electrically separates the first conductive material of the base layer from the second conductive material of over-layer sections. DE 10 2010 011604 describes a composite assembly of plastic and metal films which can be used for the interconnection and connection of light-emitting diodes. For this purpose, a flexible printed circuit board is provided, to which at least one radiation source is applied and which consists of a film system. The flexible printed circuit board has a thermal connection to a heat sink and the film system is composed at least of an insulating carrier layer and a metal film. The insulating carrier layer is opened at the locations at which the thermal connection to the heat sink is produced, and the metal film is subdivided into different sections.

Accordingly, it is desirable to provide a semiconductor light emitting device package that is freed from the constraints and drawbacks associated with mounting on a standard IMS. It is further desirable for such a semiconductor light emitting device package to be adaptable and conformable to a plurality of complex shapes and eliminate the limitations associated with wirebonds.

Various embodiments of the invention address the aforementioned drawbacks by providing a flexible interconnect structure for connecting an array of light emitting semiconductor chips.

The invention resides in a light emitting semiconductor (LES) device according to claim 1 and a method of forming a light emitting semiconductor (LES) according to claim 9.

Various advantages and features will be more readily understood from the following detailed description of preferred embodiments of the invention that is provided in connection with the accompanying drawings.

The drawings illustrate embodiments presently contemplated for carrying out the invention.

In the drawings:
FIG. 1 is a cross-sectional view of a light emitting semiconductor (LES) device including an array of LES chips and a flexible interconnect structure positioned around a cylindrical heatsink according to an embodiment of the invention.
FIG. 2 is a plan view of a portion of the LES device of FIG. 1 looking radially inward according to an embodiment of the invention.
FIG 3. is another plan view of a portion of the LES device of FIG. 1 according to an embodiment of the invention.
FIG. 4 is a schematic cross-sectional view of an LES chip and flexible interconnect structure of the LES device of FIG. 1 according to an embodiment not forming part of the invention.
FIG. 5 is a schematic cross-sectional view of an LES chip and flexible interconnect structure of the LES device of FIG. 1 according an embodiment of the invention.

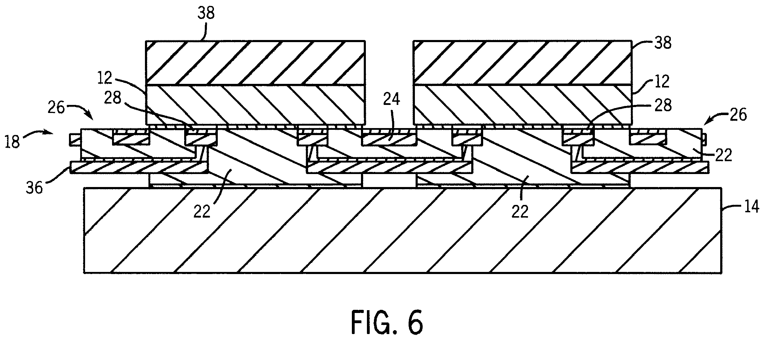

FIG. 6 is a schematic cross-sectional view of an LES chip and flexible interconnect structure of an LES device according to another embodiment of the invention. Embodiments of the present invention provide for a light emitting semiconductor (LES) device having a flexible interconnect structure. The flexible interconnect structure provides for the arrangement of an array of LES chips in various complex shapes, with the flexible interconnect structure being configured to conform around such complex shapes will still providing a robust interconnect to the LES chips. The flexible interconnect structure eliminates the need for traditional insulated metal substrates (IMS) and wirebonds in an LES device. According to embodiments of the invention, the LES device may incorporate light emitting diode (LED) chips or other suitable non-diode type light emitting semiconductor chips, and all such embodiments are considered to be within the scope of the invention.

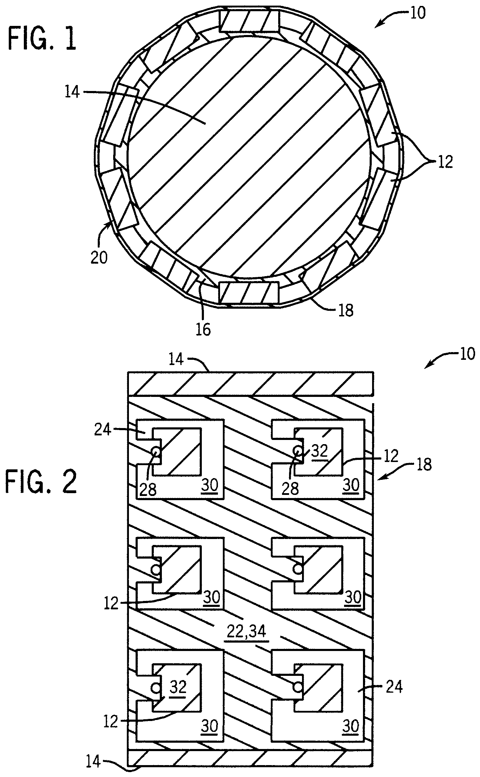

Referring to FIG. 1, a light emitting semiconductor (LES) device 10 is shown according to an embodiment of the invention. The LES device 10 includes an array of LES chips or dies 12 arranged in a specified pattern and shape to provide a desired illumination coverage to be generated by LES device 10. According to an exemplary embodiment of the invention, the LES chips 12 are in the form of light emitting diode (LED) chips, although it is recognized that the LES chips 12 could also be in the form of other suitable non-diode type light emitting semiconductor chips. The array of LES chips 12 can be arranged in a cylindrical fashion, as illustrated in FIG. 1, to provide a multidirectional lighting device, or can be arranged in any other desired fashion/pattern. According to the embodiment shown in FIG. 1, LES device 10 is in the form of a multidirectional lighting device that provides illumination over a 360 degree area or range (i.e., LES chips 12 are positioned/arranged to emit light over a 360 degree area), such that LES device 10 is constructed/configured similar to an incandescent bulb type lighting device, for example. It is recognized, however, that the array of LES chips 12 can be provided in any number of arrangements, such as might be found in round lamp bulbs, flood lights, or cylindrical flashlights. As shown in FIG. 1, the array of LES chips 12 are positioned about a heatsink 14 and are secured thereto by way of a solder or silver epoxy layer 16, for example. The heatsink 14 can be formed of aluminum or another suitable material to provide cooling to the array of LES chips 12 by drawing heat away therefrom that is generated during operation of the LES device 10. The heatsink 14 can also include fins or channels through which air or liquid can be passed through to enhance the cooling.

In addition to acting as a cooling mechanism, heatsink 14 also forms part of either a cathode or anode of the LES device, depending on the configuration of LES device 10, and thereby functions as either a cathode or anode connection for LES chips 12. That is, as LES chips 12 are directly attached to heatsink 14 (by way of solder/silver epoxy layer 16) without the inclusion of a dielectric layer therebetween (e.g., insulated metal substrate), such as in the prior art device of FIG. 1, the heatsink 14 can function as either a cathode or anode connection.

Also included in LES device 10 is a flexible interconnect structure 18 that functions to provide for controlLES operation of the array of LES chips 12. The flexible interconnect structure 18 is formed on an outward facing surface of LES device 10, on a front surface 20 of LES chips 12 from which light is emitted during operation of the LES device. The flexible interconnect structure 18 generally conforms to the shape/pattern in which the array of LES chips 12 are arranged. Thus, as seen in FIG. 1 for example, the flexible interconnect structure 18 has a generally circular/cylindrical profile that matches that of the array of LES chips 12 mounted on the cylindrically shaped heatsink 14.

A more detailed view of flexible interconnect structure 18 is provided in FIGS. 2-4.

As shown therein, flexible interconnect structure 18 includes a plurality of metal interconnects 22 (i.e., copper traces) formed and patterned onto a flexible film 24. According to an embodiment of the invention, the flexible film 24 is composed of a dielectric material and may be formed of such materials as polyimides, epoxies, paralyene, silicones, etc. According to one embodiment, flexible film 24 is in the form of a pre-formed laminate sheet or film that is formed of Kapton®, Ultem®, polytetrafluoroethylene (PTFE), Upilex®, polysulfone materials (e.g., Udel®, Radel®), or another polymer film, such as a liquid crystal polymer (LCP) or a polyimide material. Thus, in one embodiment of the invention, flexible film 24 may be formed/provided to have adhesive properties, so as to adhere directly to each LES chip 12 in the array. However, it is recognized that, alternatively, a separate adhesive layer (not shown) may be included between the flexible dielectric film 24 and the array of LES chips 12 to adhere the components together.

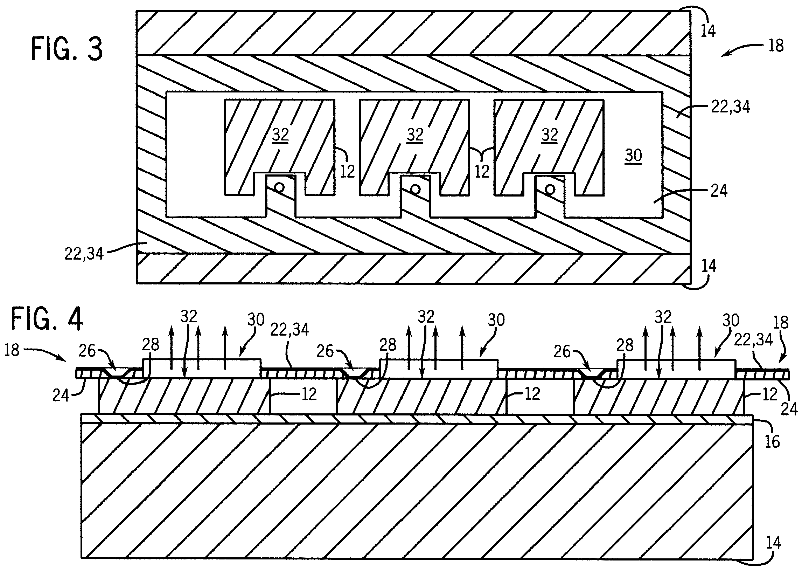

As shown in FIG. 4, the flexible film 24 is selectively patterned to form a plurality of vias 26 therein. The vias 26 are formed at positions corresponding to connection pads (i.e., contact pads) 28 formed on LES chips 12 through which an electrical connection can be made to LES chips 12, so as to expose the connection pads 28. According to one embodiment of the invention, the vias 26 are formed through the flexible film 24 by way of a laser ablation or laser drilling process that is performed subsequent to application of the flexible film 24 onto LES chips 12. Alternatively, the vias/openings 26 may be pre-formed in flexible film 24 by way of a laser ablation or laser drilling process that is performed prior to application thereof onto LES chips 12. According to additional embodiments of the invention, it is also recognized that vias 26 may be formed by way of other methods, including plasma etching, photo-definition, or mechanical drilling processes.

As further shown in FIG. 4, the metal interconnects 22 of flexible interconnect structure 18 are formed along the top surface of flexible film 24 and also formed within each of vias 26 to extend down therethrough to connection pads 28 on the LES chips 12. Metal interconnects 22 thus form direct metallic and electrical connections to connection pads 28. According to one embodiment, metal interconnects 22 are formed by way of applying a metal layer/material, such as via a sputtering or electroplating process, and then subsequently patterning the applied metal material into metal interconnects 22 having a desired shape. According to one embodiment, the metal interconnects 22 are formed by applying a titanium adhesion layer and copper seed layer via a sputtering process, followed by electroplating of additional copper thereon to increase a thickness of the metal interconnects 22 and form copper traces.

As shown in FIGS. 2-4, according to an example not forming part of the invention, the metal interconnects 22 and flexible film 24 are both formed and patterned to also include a plurality of openings 30 therein. The openings 30 are formed in flexible interconnect structure 18 in areas adjacent to LES chips 12, with the openings 30 forming windows through which an active area 32 (i.e., light emitting area) on the front surface 20 of LES chips 12 are exposed. The windows/openings 30 can either be left open or filled with an encapsulant (e.g., silicone) to protect the active areas 32, according to embodiments of the invention. Light emitted from the active area 32 of LES chips 12 is thus permitted to pass through the window 30 of flexible interconnect structure 18 without any interference from flexible film 24 or metal interconnects 22. According an embodiment of the invention, metal interconnects 22 are formed to include a film of reflective material 34 (e.g., aluminum, etc.) coated on an outer surface thereof. The coated film 34 is configured so as to have a high spectral reflectance in the wavelength regime of interest, so as to maximize reflection and reduce optical losses in LES device 10. Optical performance of LES device 10 can thus be improved by inclusion of the reflective film 34 on metal interconnects 22.

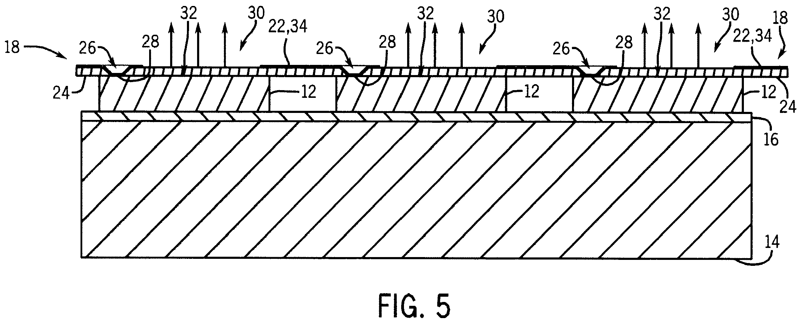

According to the embodiment of the invention, and as shown in FIG. 5, the flexible film 24 of flexible interconnect structure 18 is provided in the form of a continuous layer, without any openings (such as openings 30) formed therein. In such an embodiment, the flexible film 24 is formed from a transparent dielectric material that permits light to pass therethrough (i.e., high optical transmission). The material from which transparent flexible film 24 should be further selected to match the optical properties of the surrounding medium (i.e., air or silicone encapsulant), so as to minimize reflection at its interface with the surrounding medium. More specifically, transparent flexible film 24 is configured such that total internal reflection (TIR) within the film is avoided, with an angle of incidence being lower than a critical angle so as to avoid TIR.

Thus, light emitted from the active area 32 of LES chips 12 is permitted to pass through the flexible film 24 of flexible interconnect structure 18 without any interference therefrom. According to embodiments of the invention, the transparent flexible film 24 may have adhesive properties, so as to adhere directly to each LES chip 12 in the array. However, it is recognized that, alternatively, a separate transparent adhesive layer (not shown) may be included between the transparent flexible film 24 and the array of LES chips 12 to adhere the components together, with the adhesive having optical properties closely matching that of the transparent film. While flexible film 24 may thus be formed as a continuous layer of dielectric material, it is recognized that the metal interconnects 22 are formed and patterned to form windows/openings in areas adjacent to the active area 32 of LES chips 12, such that the metal interconnects 22 do not interfere with light emitted from the active area 32.

Referring now to FIG. 6, an additional embodiment of LES device 10 is shown, where LES chips 12 include contact pads 28 on a backside/back surface thereof, rather than on the front surface. In such an embodiment, flexible interconnect structure 18 is formed along the back surface of the array of LES chips 12 and is positioned between the LES chips 12 and the heatsink 14. Flexible interconnect structure 18 includes metal interconnects 22 formed and patterned onto flexible film 24, with the interconnects extending through vias 26 formed in film 24 so as to extend therethrough to connection pads 28 on the LES chips 12. In the embodiment of FIG. 6, metal interconnects 22 serve as the electrical interconnect with heatsink 14 and also serve as a 'heat spreader' (i.e., thermal re-distribution layer) between the LES chips 12 and the heatsink 14. As shown in FIG. 6, an additional layer 36 is added to interconnect structure 18, such as a second flexible dielectric film layer or a solder mask, in order to provide a double layer POL interconnect structure 18. A silicon encapsulant 38 is positioned on the light emitting surface of LES chips 12 to provide protection thereto.

Beneficially, incorporation of flexible interconnect structure 18 in LES device 10 provides for the arrangement of the array of LES chips 12 in various complex shapes. That is, the flexible interconnect structure 18 can conform around complex shapes, such as shapes typical in general incandescent lighting for example, with the flexible interconnect structure 18 still providing a robust interconnect to the LES chips 12. The flexible interconnect structure 18 also eliminates the need for traditional wirebonds and insulated metal substrates (IMS) in an LES device, thereby providing a low resistance and low inductance interconnects between the LES array 12 and the LES driver electronics. With the elimination of the IMS, thermal resistance in the LES device 10 is reduced, as LES chips 12 are directly mounted onto heatsink 14 without the presence of a dielectric layer therebetween, thus providing an LES device 10 with improved thermal performance and higher lumen output.

Therefore, according to one embodiment of the invention, a light emitting semiconductor (LES) device includes a heatsink and an array of LES chips mounted on the heatsink and electrically connected thereto, each LES chip comprising a front surface and a back surface with the front surface including a light emitting area configured to emit light therefrom responsive to a received electrical power and with at least one of the front surface and the back surface including a connection pads thereon. The LES device also includes a flexible interconnect structure positioned on and electrically connected to each LES chip to provide for controlLES operation of the array of LES chips, with the flexible interconnect structure further including a flexible dielectric film configured to conform to a shape of the heatsink and a metal interconnect structure formed on the flexible dielectric film, with the metal interconnect structure extending through vias formed through the flexible dielectric film so as to be electrically connected to the connection pads of the LES chips.

According to another embodiment of the invention, a multidirectional lighting device includes a heatsink having a curved profile and an array of light emitting semiconductor (LES) chips affixed to the heatsink so as to be electrically connected thereto, with the array of LES chips being arranged so as to have a curved profile that substantially matches that of the heatsink, and wherein each LES chip comprises a front surface including a connection pad and a light emitting area configured to emit light therefrom responsive to a received electrical power. The multidirectional lighting device also includes a flexible interconnect structure positioned on the array of LES chips and being electrically connected to each of the LES chips, with the flexible interconnect structure further including a flexible dielectric film configured to conform to the curved profile of the array of LES chips and a metal interconnect structure formed on the flexible dielectric film, the metal interconnect structure extending through vias formed through the flexible dielectric film so as to be electrically connected to the connection pads of the LES chips.

According to yet another embodiment of the invention, a method of forming a light emitting semiconductor (LES) device includes providing a plurality of LES chips forming an LES array and connecting a flexible dielectric film to each of the plurality of LES chips in the LES array, with the flexible dielectric film configured to flex so as to conform substantially to the profile of the LES array. The method also includes forming a metal interconnect structure on the flexible dielectric film to electrically connect the plurality of LES chips, with the metal interconnect structure extending through vias in the flexible dielectric film so as to be electrically connected to contact pads of the LES chips. The method further includes securing the plurality of LES chips to a heatsink such that the plurality of LES chips is electrically connected to the heatsink and such that the LES array has a profile that matches a profile of the heatsink.

While the invention has been described in detail in connection with only a limited number of embodiments, it should be readily understood that the invention is not limited to such disclosed embodiments. Additionally, while various embodiments of the invention have been described, it is to be understood that aspects of the invention may include only some of the described embodiments. Accordingly, the invention is not to be seen as limited by the foregoing description, but is only limited by the scope of the appended claims.

Various aspects and embodiments of the present invention are described in the following numbered clauses:
1. A light emitting semiconductor (LES) device comprising:
   a heatsink;
   an array of LES chips mounted on the heatsink and electrically connected thereto, each LES chip comprising a front surface and a back surface, with the front surface including a light emitting area configured to emit light therefrom responsive to a received electrical power and with at least one of the front surface and the back surface including connection pads thereon; and
   a flexible interconnect structure positioned on and electrically connected to each LES chip to provide for controlled operation of the array of LES chips, the flexible interconnect structure comprising:
      a flexible dielectric film configured to conform to a shape of the heatsink; and
   a metal interconnect structure formed on the flexible dielectric film, the metal interconnect structure extending through vias formed through the flexible dielectric film so as to be electrically connected to the connection pads of the LES chips.
2. The LES device of clause 1 wherein the heatsink is constructed to have one of a curved surface and a flat surface, and wherein an arrangement of the array of LES chips follows the surface of the heatsink.
3. The LES device of any preceding clause wherein the heatsink is constructed to include a plurality of fins or channels configured to allow for air or liquid cooling.
4. The LES device of any preceding clause wherein the heatsink is constructed to have a circular shape such that the array of LES chips mounted thereon are positioned to emit light over a 360 degree area.
5. The LES device of any preceding clause wherein the metal interconnect structure comprises a plurality of copper traces formed on the flexible dielectric film.
6. The LES device of any preceding clause wherein the metal interconnect structure is patterned so as to include openings therein corresponding to locations of the light emitting area of each respective LES chip.
7. The LES device of any preceding clause wherein the heatsink is configured to function as an anode connection or a cathode connection in the LES device.
8. The LES device of any preceding clause wherein heat generated by the array of LES chips is transmitted to the heatsink for heat dissipation.
9. The LES device of any preceding clause further comprising one of an electrically conductive solder material, an electrically conductive adhesive, and sintered silver, included between the heatsink and the array of LES chips to secure the array of LES chips to the heatsink.
10. The LES device of any preceding clause wherein the flexible dielectric film is configured to adhere to the array of LES chips.
11. The LES device of any preceding clause wherein the flexible interconnect structure is free of wirebond connections.
12. The LES device of any preceding clause wherein the flexible dielectric film includes a plurality of openings formed therein corresponding to locations of the light emitting area of each respective LES chip.
13. The LES device of any preceding clause wherein the flexible dielectric film comprises a transparent film configured to permit light emitted from the light emitting area of each respective LES chip to pass therethrough.
14. The LES device of any preceding clause wherein the connection pads are formed on the front surface of the LES chips, and wherein the flexible interconnect structure is positioned on the front surface of the LES chips.
15. The LES device of any preceding clause wherein the connection pads are formed on the back surface of the LES chips, and wherein the flexible interconnect structure is positioned on the back surface of the LES chips, with the metal interconnect structure electrically connecting the LES chips and the heatsink and comprising a heat spreader between the LES chips and the heatsink.
16. The LES device of any preceding clause wherein the metal interconnect structure comprises a reflective film coated on an outer surface thereof, the reflective film configured to a increase a spectral reflectance of the metal interconnect structure so as to maximize reflection and reduce optical losses in the LES device.
17. A multidirectional lighting device comprising:
   a heatsink having a curved profile;
   an array of light emitting semiconductor (LES) chips affixed to the heatsink so as to be electrically connected thereto, the array of LES chips being arranged so as to have a curved profile that substantially matches that of the heatsink, and wherein each LES chip comprises a front surface including a connection pad and a light emitting area configured to emit light therefrom responsive to a received electrical power; and
   a flexible interconnect structure positioned on the array of LES chips and being electrically connected to each of the LES chips, the flexible interconnect structure comprising:
   a flexible dielectric film configured to conform to the curved profile of the array of LES chips; and
   a metal interconnect structure formed on the flexible dielectric film, the metal interconnect structure extending through vias formed through the flexible dielectric film so as to be electrically connected to the connection pads of the LES chips.
18. The multidirectional lighting device of any preceding clause wherein the metal interconnect structure comprises a plurality of copper traces formed on the flexible dielectric film.
19. The multidirectional lighting device of any preceding clause wherein the flexible dielectric film includes a plurality of openings formed adjacent locations of the light emitting area of each respective LES chip, and wherein the metal interconnect structure is patterned so as to include openings therein corresponding to the openings of the flexible dielectric film.
20. The multidirectional lighting device of any preceding clause wherein the heatsink is configured to function as one of a cathode connection and an anode connection in the LES device.
21. The multidirectional lighting device of any preceding clause further comprising an electrically conductive material included between the heatsink and the array of LES chips to secure the array of LES chips to the heatsink.
22. The multidirectional lighting device of any preceding clause wherein the heatsink is constructed to have a circular shape such that the array of LES chips mounted thereon are arranged to emit light over a 360 degree coverage area.
23. The multidirectional lighting device of any preceding clause wherein the an array of LES chips is affixed directly to the heatsink without the use of an insulated metal substrate (IMS) therebetween, and wherein the flexible interconnect structure is free of wirebond connections.
24. The multidirectional lighting device of any preceding clause wherein the flexible interconnect structure is positioned on a back surface of the array of LES chips, between the array of LES chips and the heatsink; and
   wherein the flexible interconnect structure is configured to electrically connect the array of LES chips to the heatsink and function as a heat spreader between the array of LES chips and the heatsink.
25. A method of forming a light emitting semiconductor (LES) device comprising:
   providing a plurality of LES chips, with the plurality of LES chips forming an LES array;
   connecting a flexible dielectric film to each of the plurality of LES chips in the LES array, the flexible dielectric film configured to flex so as to conform substantially to the profile of the LES array;
   forming a metal interconnect structure on the flexible dielectric film to electrically connect the plurality of LES chips, the metal interconnect structure extending through vias in the flexible dielectric film so as to be electrically connected to contact pads of the LES chips; and
   securing the plurality of LES chips to a heatsink, such that the plurality of LES chips is electrically connected to the heatsink and such that the LES array has a profile that matches a profile of the heatsink.
26. The method of any preceding clause wherein securing the plurality of LES chips on the heatsink comprises solder attaching the plurality of LES chips to the heatsink.
27. The method of any preceding clause wherein the heatsink has a curved, non-planar profile and wherein the LES array has a corresponding curved, non-planar profile, such that the LES array is configured to emit light in a multidirectional pattern.
28. The method of any preceding clause further comprising forming a plurality of openings in the flexible dielectric film adjacent locations of a light emitting area of each respective LES chip.

## Claims

1. A light emitting semiconductor (LES) device (10) comprising:
a heatsink (14);
an array of LES chips (12) mounted on the heatsink (14) and electrically connected thereto, each LES chip (12) comprising a front surface and a back surface, with the front surface including a light emitting area (32) configured to emit light therefrom responsive to a received electrical power and with at least one of the front surface and the back surface including connection pads (28) thereon; and
a flexible interconnect structure (18) positioned on and electrically connected to each LES chip (12) to provide for controlled operation of the array of LES chips (12), the flexible interconnect structure (18) comprising:
a flexible dielectric film (24) configured to conform to a shape of the heatsink (14); and
a metal interconnect structure (22) formed on the flexible dielectric film (24), the metal interconnect structure (22) extending through vias (26) formed through the flexible dielectric film (24) so as to be electrically connected to the connection pads (28) of the LES chips (12); **characterized in that**
the flexible dielectric film (24) comprises a continuous transparent film without any openings formed therein and configured to permit light emitted from the light emitting area (32) of each respective LES chip to pass therethrough.

2. The LES device (10) of claim 1, wherein the heatsink (14) is constructed to have one of a curved surface and a flat surface, and wherein an arrangement of the array of LES chips (12) follows the surface of the heatsink (14).

3. The LES device (10) of any preceding claim, wherein the heatsink (14) is constructed to have a circular shape such that the array of LES chips (12) mounted thereon are positioned to emit light over a 360 degree area.

4. The LES device (10) of any preceding claim, wherein the metal interconnect structure (22) is patterned so as to include openings (30) therein corresponding to locations of the light emitting area (32) of each respective LES chip.

5. The LES device (10) of any preceding claim, wherein the heatsink (14) is configured to function as an anode connection or a cathode connection in the LES device (10).

6. The LES device (10) of any preceding claim, wherein the connection pads (28) are formed on the front surface of the LES chips (12), and wherein the flexible interconnect structure (18) is positioned on the front surface of the LES chips (12).

7. The LES device (10) of any preceding claim, wherein the connection pads (28) are formed on the back surface of the LES chips (12), and wherein the flexible interconnect structure (18) is positioned on the back surface of the LES chips (12), with the metal interconnect structure (22) electrically connecting the LES chips (12) and the heatsink (14) and comprising a heat spreader between the LES chips (12) and the heatsink (14).

8. The LES device (10) of any preceding claim, wherein the metal interconnect structure (22) comprises a reflective film (34) coated on an outer surface thereof, the reflective film (34) configured to increase spectral reflectance of the metal interconnect structure (22) so as to maximize reflection and reduce optical losses in the LES device (10).

9. A method of forming a light emitting semiconductor (LES) device (10) comprising:
providing a plurality of LES chips (12), with the plurality of LES chips (12) forming an LES array, each LES chip (12) comprising a front surface and a back surface, with the front surface including a light emitting area (32);
connecting a flexible dielectric film (24) to each of the plurality of LES chips (12) in the LES array, the flexible dielectric film (24) configured to flex so as to conform substantially to the profile of the LES array, wherein the flexible dielectric film comprises a continuous transparent film without any openings formed therein, and configured to permit light emitted from the light emitting area (32) of each respective LES chip to pass therethrough;
forming a metal interconnect structure (22) on the flexible dielectric film (24) to electrically connect the plurality of LES chips (12), the metal interconnect structure (22) extending through vias (26) in the flexible dielectric film (22) so as to be electrically connected to contact pads (28) of the LES chips (12); and
securing the plurality of LES chips (12) to a heatsink (14), such that the plurality of LES chips (12) is electrically connected to the heatsink (14) and such that the LES array has a profile that matches a profile of the heatsink (14).

10. The method of claim 9, wherein securing the plurality of LES chips (12) on the heatsink (14) comprises solder attaching the plurality of LES chips (12) to the heatsink (14).

11. The method of any of claims 9 or 10, wherein the heatsink (14) has a curved, non-planar profile and wherein the LES array has a corresponding curved, non-planar profile, such that the LES array is configured to emit light in a multidirectional pattern.

## Patentansprüche

1. Lichtemittierendes Halbleiter- (LES-) Bauelement (10), umfassend:
einen Kühlkörper (14);
eine Gruppierung von LES-Chips (12), die am Kühlkörper (14) angebracht und elektrisch damit verbunden sind; wobei jeder LES-Chip (12) eine Vorderfläche und eine Rückfläche umfasst, wobei die Vorderfläche einen lichtemittierenden Bereich (32) enthält, der zum Emittieren von Licht davon in Reaktion auf eine empfangene elektrische Leistung konfiguriert ist, und wobei zumindest eine der Vorderfläche und der Rückfläche Verbindungskontaktflächen (28) darauf enthält; und
eine flexible Verbindungsstruktur (18), die auf jedem LES-Chip (12) angeordnet und damit verbunden ist, um gesteuerten Betrieb der Gruppierung von LES-Chips (12) vorzusehen, wobei die flexible Verbindungsstruktur (18) folgendes umfasst:
eine flexible dielektrische Folie (24), die dazu konfiguriert ist, mit einer Form des Kühlkörpers (14) konform zu sein; und
eine metallische Verbindungsstruktur (22), die auf der flexiblen dielektrischen Folie (24) ausgebildet ist, wobei die metallische Verbindungsstruktur (22) durch Durchgänge (26) verläuft, die durch die flexible dielektrische Folie ausgebildet sind, um mit den Verbindungskontaktflächen (28) der LES-Chips (12) elektrisch verbunden zu sein; **dadurch gekennzeichnet, dass**
die flexible dielektrische Folie (24) eine fortlaufende transparente Folie ohne jegliche Öffnungen darin umfasst und zum Ermöglichen konfiguriert ist, dass Licht, welches vom lichtemittierenden Bereich (32) jedes jeweiligen LES-Chips emittiert wird, dort hindurchgeht.

2. LES-Bauelement (10) nach Anspruch 1, wobei der Kühlkörper (14) derart gebaut ist, dass er eine von einer gekrümmten Oberfläche und einer flachen Oberfläche aufweist, und wobei eine Anordnung der Gruppierung von LES-Chips (12) der Oberfläche des Kühlkörpers (14) folgt.

3. LES-Bauelement (10) nach einem der vorhergehenden Ansprüche, wobei der Kühlkörper (14) derart gebaut ist, dass er eine kreisförmige Form aufweist, sodass die Gruppierung von LES-Chips (12), die darauf angebracht ist, zum Emittieren von Licht über einen 360-Grad-Bereich angeordnet sind.

4. LES-Bauelement (10) nach einem der vorhergehenden Ansprüche, wobei die metallische Verbindungsstruktur (22) derart gemustert ist, dass sie Öffnungen (30) darin enthält, die den Lagen des lichtemittierenden Bereichs (32) von jedem jeweiligen LES-Chip entsprechen.

5. LES-Bauelement (10) nach einem der vorhergehenden Ansprüche, wobei der Kühlkörper (14) zum Funktionieren als eine Anodenverbindung oder eine Kathodenverbindung im LES-Bauelement (10) konfiguriert ist.

6. LES-Bauelement (10) nach einem der vorhergehenden Ansprüche, wobei die Verbindungskontaktflächen (28) auf der Vorderfläche der LES-Chips (12) ausgebildet sind, und wobei die flexible Verbindungsstruktur (18) auf der Vorderfläche der LES-Chips (12) angeordnet ist.

7. LES-Bauelement (10) nach einem der vorhergehenden Ansprüche, wobei die Verbindungskontaktflächen (28) auf der Rückfläche der LES-Chips (12) ausgebildet sind, und wobei die flexible Verbindungsstruktur (18) auf der Rückfläche der LES-Chips (12) angeordnet ist, wobei die metallische Verbindungsstruktur (22) die LES-Chips (12) elektrisch mit dem Kühlkörper (14) verbindet und einen Wärmeverteiler zwischen den LES-Chips (12) und dem Kühlkörper (14) umfasst.

8. LES-Bauelement (10) nach einem der vorhergehenden Ansprüche, wobei die metallische Verbindungsstruktur (22) eine reflektierende Folie (34) umfasst, die auf eine Außenfläche davon geschichtet ist, wobei die reflektierende Folie (34) zum Erhöhen des spektralen Reflexionsanteils der metallischen Verbindungsstruktur (22) konfiguriert ist, um Reflektion zu maximieren und optische Verluste im LES-Bauelement (10) zu verringern.

9. Verfahren zum Ausbilden eines lichtemittierenden Halbleiter- (LES-) Bauelements (10), umfassend:
Vorsehen von mehreren LES-Chips (12), wobei die mehreren LES-Chips (12) eine LES-Gruppierung ausbilden, wobei jeder LES-Chip (12) eine Vorderfläche und eine Rückfläche umfasst, wobei die Vorderfläche einen lichtemittierenden Bereich (32) enthält;
Verbinden einer flexiblen dielektrischen Folie (24) mit jedem der mehreren LES-Chips (12) in der LES-Gruppierung, wobei die flexible dielektrische Folie (24) dazu konfiguriert ist, sich zu biegen, um im Wesentlichen mit dem Profil der LES-Gruppierung konform zu sein, wobei die flexible dielektrische Folie eine fortlaufende transparente Folie ohne jegliche darin ausgebildete Öffnungen umfasst und zum Ermöglichen konfiguriert ist, dass Licht, das vom lichtemittierenden Bereich (32) jedes jeweiligen LES-Chips emittiert wird, dort hindurchgeht;
Ausbilden einer metallischen Verbindungsstruktur (22) auf der flexiblen dielektrischen Folie (24) zum elektrischen Verbinden der mehreren LES-Chips (12), wobei die metallische Verbindungsstruktur (22) durch Durchgänge (26) in der flexiblen dielektrischen Folie (22) verläuft, um mit den Verbindungskontaktflächen (28) der LES-Chips (12) elektrisch verbunden zu sein; und
Befestigen der mehreren LES-Chips (12) am Kühlkörper (14), sodass die mehreren LES-Chips (12) elektrisch mit dem Kühlkörper (14) verbunden sind, und sodass die LES-Gruppierung ein Profil aufweist, das mit dem Profil des Kühlkörpers (14) übereinstimmt.

10. Verfahren nach Anspruch 9, wobei das Befestigen der mehreren LES-Chips (12) auf dem Kühlkörper (14) Lot umfasst, das die mehreren LES-Chips (12) am Kühlkörper (14) anbringt.

11. Verfahren nach einem der Ansprüche 9 oder 10, wobei der Kühlkörper (14) ein gekrümmtes, nicht-planes Profil aufweist, und wobei die LES-Gruppierung ein entsprechendes gekrümmtes, nicht-planes Profil aufweist, sodass die LES-Gruppierung zum Emittieren von Licht in einem Mehrfachrichtungsmuster konfiguriert ist.

## Revendications

1. Dispositif semi-conducteur luminescent (LES) (10) comprenant :
un puits de chaleur (14) ;
un réseau de puces LES (12) montées sur le puits de chaleur (14) et connectées électriquement à celui-ci, chaque puce LES (12) comprenant une surface avant et une surface arrière, la surface avant comprenant une zone émettrice de lumière (32) configurée pour émettre de la lumière à la suite de la réception d'une puissance électrique, au moins l'une de la surface avant et de la surface arrière portant des plots de connexion (28) ; et
une structure d'interconnexion flexible (18) positionnée et connectée électriquement à chaque puce LES (12) pour assurer le fonctionnement commandé du réseau de puces LES (12), la structure d'interconnexion flexible (18) comprenant :
un film diélectrique flexible (24) configuré pour répondre à la forme du puits de chaleur (14) ; et
une structure d'interconnexion métallique (22) formée sur le film diélectrique flexible (24), la structure d'interconnexion métallique (22) s'étendant à travers des voies d'interconnexion (26) formées à travers le film diélectrique flexible (24) de manière à être connectée électriquement aux plots de connexion (28) des puces LES (12) ; **caractérisé en ce que** :
le film diélectrique flexible (24) comprend un film transparent continu sans ouvertures quelconques qui y sont formées et configuré pour permettre à la lumière émise par la zone émettrice de lumière (32) de chaque puce LES respective de le traverser.

2. Dispositif LES (10) selon la revendication 1, dans lequel le puits de chaleur (14) est conçu pour avoir l'une d'une surface incurvée et d'une surface plate et dans lequel un aménagement du réseau de puces LES (12) suit la surface du puits de chaleur (14).

3. Dispositif LES (10) selon l'une quelconque des revendications précédentes, dans lequel le puits de chaleur (14) est conçu pour avoir une forme circulaire de sorte que le réseau de puces LES (12) qui y est monté soit positionné pour émettre de la lumière sur une surface de 360 degrés.

4. Dispositif LES (10) selon l'une quelconque des revendications précédentes, dans lequel la structure d'interconnexion métallique (22) est configurée pour y inclure des ouvertures (30) correspondant à des emplacements de la zone émettrice de lumière (32) de chaque puce respective du LES.

5. Dispositif LES (10) selon l'une quelconque des revendications précédentes, dans lequel le puits de chaleur (14) est configuré pour fonctionner comme connexion anodique ou connexion cathodique dans le dispositif LES (10).

6. Dispositif LES (10) selon l'une quelconque des revendications précédentes, dans lequel les plots de connexion (28) sont formés sur la surface avant des puces LES (12) et dans lequel la structure d'interconnexion flexible (18) est positionnée sur la surface avant des puces LES (12).

7. Dispositif LES (10) selon l'une quelconque des revendications précédentes, dans lequel les plots de connexion (28) sont formés sur la surface arrière des puces LES (12) et dans lequel la structure d'interconnexion flexible (18) est positionnée sur la surface arrière des puces LES (12), la structure d'interconnexion métallique (22) connectant électriquement les puces LES (12) et le puits de chaleur (14) et comprenant un diffuseur de chaleur entre les puces LES (12) et le puits de chaleur (14).

8. Dispositif LES (10) selon l'une quelconque des revendications précédentes, dans lequel la structure d'interconnexion métallique (22) comprend un film réfléchissant (34) appliqué sur sa surface externe, le film réfléchissant (34) étant configuré pour augmenter la capacité de réflexion spectrale de la structure d'interconnexion métallique (22) de manière à maximiser la réflexion et à réduire les pertes optiques dans le dispositif LES (10).

9. Procédé de formation d'un dispositif semi-conducteur luminescent (LES) (10) comprenant :
la fourniture d'une pluralité de puces LES (12), la pluralité de puces LES (12) formant un réseau LES, chaque puce LES (12) comprenant une surface avant et une surface arrière, la surface avant comprenant une zone émettrice de lumière (32) ;
la connexion d'un film diélectrique flexible (24) à chacune de la pluralité de puces LES (12) dans le réseau LES, le film diélectrique flexible (24) étant configuré pour fléchir de manière à se conformer sensiblement au profil du réseau LES, dans lequel le film diélectrique flexible comprend un film transparent continu sans ouvertures quelconques qui y soient formées, et configuré pour permettre à la lumière émise par la zone émettrice de lumière (32) de chaque puce LES respective de le traverser ;
la formation d'une structure d'interconnexion métallique (22) sur le film diélectrique flexible (24) pour se connecter électriquement à la pluralité de puces LES (12), la structure d'interconnexion métallique (22) s'étendant à travers des voies d'interconnexion (26) dans le film diélectrique flexible (22) de manière à être connectée électriquement à des plots de contact (28) des puces LES (12) ; et
la fixation de la pluralité de puces LES (12) à un puits de chaleur (14) de sorte que la pluralité de puces LES (12) soit connectée électriquement au puits de chaleur (14) et que le réseau LES ait un profil qui concorde avec le profil du puits de chaleur (14).

10. Procédé selon la revendication 9, dans lequel la fixation de la pluralité de puces LES (12) sur le puits de chaleur (14) comprend la fixation par brasure de la pluralité de puces LES (12) au puits de chaleur (14).

11. Procédé selon l'une quelconque des revendications 9 ou 10, dans lequel le puits de chaleur (14) a un profil non planaire incurvé et dans lequel le réseau LES a un profil non planaire incurvé correspondant de sorte que le réseau LES soit configuré pour émettre de la lumière selon un motif multidirectionnel.
